(19) **Europäisches Patentamt**
**European Patent Office**
**Office européen des brevets**

(11) **EP 4 195 449 B1**

(12) **EUROPEAN PATENT SPECIFICATION**

(45) Date of publication and mention
of the grant of the patent:
**27.05.2026 Bulletin 2026/22**

(21) Application number: **22849843.2**

(22) Date of filing: **26.07.2022**

(51) International Patent Classification (IPC):
***H02J 7/00*** *(2026.01)* ***H02J 3/32*** *(2026.01)*
***G01R 19/165*** *(2006.01)*

(52) Cooperative Patent Classification (CPC):
**G01R 31/392; H02J 3/32; H02J 7/50; H02J 7/585;**
**H02J 7/92; H02J 7/933; H02J 7/94; H02J 7/96;**
H02J 2207/20; Y02E 70/30

(86) International application number:
**PCT/KR2022/010931**

(87) International publication number:
**WO 2023/008867 (02.02.2023 Gazette 2023/05)**

(54) **ENERGY STORAGE SYSTEM AND CONTROL METHOD OF ENERGY STORAGE SYSTEM**

ENERGIESPEICHERSYSTEM UND STEUERUNGSVERFAHREN FÜR EIN
ENERGIESPEICHERSYSTEM

SYSTÈME DE STOCKAGE D'ÉNERGIE ET PROCÉDÉ DE COMMANDE DE SYSTÈME DE
STOCKAGE D'ÉNERGIE

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**

(30) Priority: **26.07.2021 KR 20210097480**

(43) Date of publication of application:
**14.06.2023 Bulletin 2023/24**

(73) Proprietor: **LG Energy Solution, Ltd.**
**Seoul 07335 (KR)**

(72) Inventor: **KIM, Jongcheol**
**Daejeon 34122 (KR)**

(74) Representative: **Plasseraud IP**
**104 Rue de Richelieu**
**CS92104**
**75080 Paris Cedex 02 (FR)**

(56) References cited:
WO-A2-2018/034711    KR-A- 20130 099 022
KR-A- 20170 041 448    KR-A- 20180 090 673
KR-A- 20200 003 586    US-A1- 2013 234 669

**Description**

[Technical Field]

The present invention relates to an energy storage system and a method of controlling the same, and more particularly, to an energy storage system including a pluraliy of power converters and a method of controlling the energy storage system.

**[Background Art]**

An energy storage system relates to renewable energy, a battery that stores electric power, and grid power. Recently, as the spread of smart grid and renewable energy is expanding and the efficiency and the stability of the power system are emphasized, a demand for energy storage systems for power supply and demand control and power quality improvement is increasing. Depending on a purpose of use, energy storage systems may have different output and capacity. In order to configure a large-capacity energy storage system, a plurality of battery systems may be connected. These energy storage systems are changing to DC-coupled energy storage systems.

An energy storage system may include a battery section with a plurality of batteries, a battery management system (BMS), a power conversion system (PCS), and an energy management system (EMS). A DC-coupled energy storage system may further require DC/DC converters.

Meanwhile, in an ESS system using a separate DC/DC converter for each battery, a method of calculating an output value of each battery at every moment through a central controller and transmitting the value as a command to each battery is generally used. However, in this instance, any appropriate solution is not presented as to how to maintain a system voltage. Document KR 2018 0090673 A discloses to maintain a DC link voltage of a DC link coupled to a plurality of batteries via respective DC converters by selectively discharging the batteries depending on their SOC.

**[Summary]**

**[Technical Problem]**

To obviate one or more problems described above, an object of the present disclosure is to provide a control method of an energy storage system.

Another object of the present disclosure for obviating one or more problems described above is to provide an energy storage system.

Yet another object of the present disclosure for obviating one or more problems described above is to provide a battery section control apparatus.

**[Technical Solution]**

According to the present invention, a control method according to claim 6 is provided.

Here, the DC link is a link between the plurality of power converters and a power conversion system (PCS) that is configured to perform AC/DC conversion between the plurality of power converters and a power grid.

The control method may further comprise controlling the other power converters except the first power converter among the plurality of power converters to perform constant power (CP) mode control or constant current (CC) mode control.

Here, a power converter among the plurality of power converters except for the first power converter may be chosen as the second power converter to perform DC link control instead of the first power converter, wherein the second power converter corresponds to a battery rack with a value of an intermediate position in terms of state of charges of the battery racks.

The checking a state of a first battery rack may include determining whether a state of charge of the first battery rack has reached an upper limit or a lower limit of a preset range of state of charge.

According to the present invention, an energy storage system according to claim 1 is provided.

Here, the battery section controller may be configured to control the other power converters except the first power converter among the plurality of power converters to perform constant power (CP) mode control or constant current (CC) mode control.

The battery section controller may also be configured to select a power converter among the plurality of power converters except for the first power converter as the second power converter to perform DC link control instead of the first power converter, wherein the second power converter corresponds to a battery rack with a value of an intermediate position in terms of state of charges of the battery racks.

The battery section controller may also be configured to determine whether a state of charge of the first battery rack has reached an upper limit or a lower limit of a preset range of SOC and decide whether to change the subject to perform CV mode control for the DC link. According to the present invention, a battery section controller according to claim 10 is provided.

Here, the at least one instruction further may include controlling the other power converters except the first power converter among the plurality of power converters to perform constant power (CP) mode control or constant current (CC) mode control.

**[Advantageous Effects]**

According to the embodiments of the present invention as described above, it is possible to stably control a DC link voltage in an energy storage system using a plurality of DC/DC converters.

In addition, since the rest of the DC/DC converters other than the DC/DC converter performing CV control use CP control or CC control, a battery section controller can actively calculate an output reference for each battery considering a state of each battery.

Furthermore, a power control system can also perform CP control as an existing way without an additional procedure, such as a software change, thereby performing grid-linked control smoothly.

**[Brief Description of the Drawings]**

FIG. 1 is a block diagram of an energy storage system to which the present invention may be applied.
FIG. 2 is a conceptual diagram of a control method of an energy storage system according to embodiments of the present invention.
FIG. 3 is an operational flowchart of a method for controlling an energy storage system according to embodiments of the present invention.

**[Detailed Description]**

The present invention may be modified in various forms and have various embodiments, and specific embodiments thereof are shown by way of example in the drawings and will be described in detail below. It should be understood, however, that there is no intent to limit the present invention to the specific embodiments, but on the contrary, the present invention is to cover all modifications, equivalents, and alternatives falling within the scope of the claims. Like reference numerals refer to like elements throughout the description of the figures.

It will be understood that, although the terms such as first, second, A, B, and the like may be used herein to describe various elements, these elements should not be limited by these terms. These terms are only used to distinguish one element from another. For example, a first element could be termed a second element, and, similarly, a second element could be termed a first element, without departing from the scope of the present invention. As used herein, the term "and/or" includes combinations of a plurality of associated listed items or any of the plurality of associated listed items.

It will be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

The terminology used herein is for the purpose of describing particular embodiments only and is not intended to be limiting of the invention. As used herein, the singular forms "a", "an" and "the" are intended to include the plural forms as well, unless the context clearly indicates otherwise. It will be further understood that the terms "comprises", "comprising,", "includes" and/or "including", when used herein, specify the presence of stated features, integers, steps, operations, elements, and/or components, but do not preclude the presence or addition of one or more other features, integers, steps, operations, elements, components, and/or groups thereof.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Hereinafter, example embodiments of the present invention will be described in detail with reference to the accompanying drawings.

The present invention proposes a solution for how to maintain a system voltage in an energy storage system including DC/DC converters, in particular, a control method of the energy storage system.

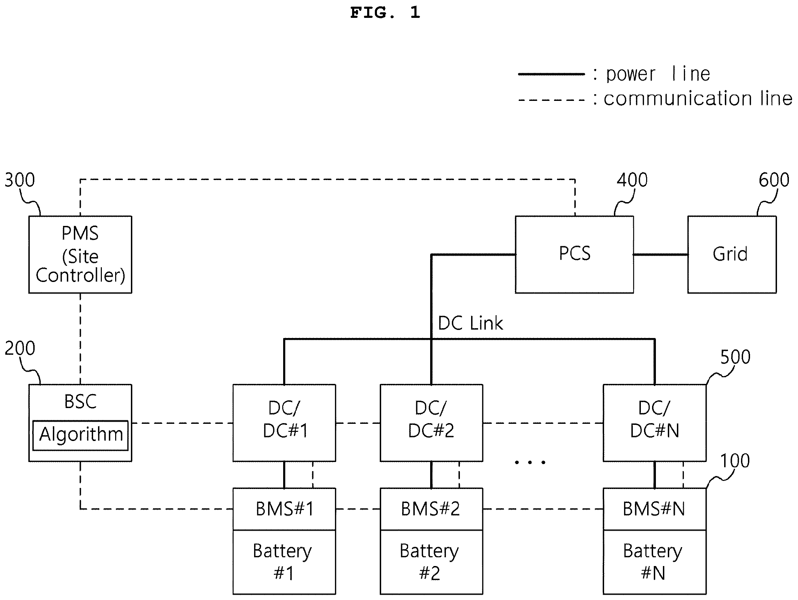

FIG. 1 is a block diagram of an energy storage system to which the present invention may be applied.

In an energy storage system (ESS), a battery is used for storing energy or power. Typycally, multiple battery modules may form a battery rack and multiple battery racks form a battery bank. Here, depending on a device or a system in which the battery is used, a battery rack may be referred to as a battery pack. Battery #1, battery #2, ... , and battery #N shown in FIG. 1 may each be in a form of a battery pack or a battery rack.

Referring to FIG. 1, a battery management system (BMS) 100 may be installed for each battery. The BMS 100 may monitor a current, a voltage and a temperature of each battery pack (or rack) to be managed, calculate a state Of charge (SOC) of the battery based on a monitoring result to control charging and discharging.

A battery section controller (BSC) 200 may be located in each battery section which includes a plurality of batteries, peripheral circuits, and devices to monitor and control objects such as a voltage, a current, a temperature, and a circuit breaker. Furthermore, the BSC 200 may calculate an output of each DC/DC converter based on the monitored state information of the battery and transmit the calculated output of DC/DC converter to the DC/DC converter.

According to embodiments of the present invention, the battery section controller may interwork with a plurality of power converters in an energy storage system including a plurality of battery racks and a plurality of power converters respectively connected to the plurality of battery racks. The battery section controller may comprise at least one processor; and a memory configured to store at least one instruction executed by the at least one processor.

The at least one instruction includes an instruction to control a first power converter among the plurality of power converters to perform constant voltage (CV) mode control for maintaining a voltage of a DC link at a constant level; an instruction to check a state of a first battery rack to which the first power converter is connected; and an instruction to change a subject to perform CV mode control for the DC link according to the state of the first battery rack.

In addition, the at least one instruction may further include controlling the other power converters except the first power converter among the plurality of power converters to perform constant power (CP) mode control or constant current (CC) mode control.

A power conversion system (PCS) 400 installed in each battery section may control power supplied from the outside and power supplied from the battery section to the outside, therby controlling charging and discharging of the battery. The power convertion system may include a DC/AC inverter. In other words, the power conversion system may convert the output of the battery (that is, DC power) into AC power and transmit it to the grid (during discharging), or in reverse, converting AC power from the grid into DC power and transferring it to the battery (during charging).

The output of the DC-DC converter 500 may be connected to the PCS 400 and the PCS 400 may be connected to the power grid 600. Here, the PCS 400 typically operates in a constant power mode. A power management system (PMS) 300 connected to the PCS may control outputs of the PCS based on the monitoring and control results of the battery management system or the battery section controller.

In the energy storage system of FIG. 1 , battery #1 is connected to DC-DC converter #1, battery #2 is connected to DC-DC converter #2, and battery #N is connected to DC-DC #N. The output of the DC-DC converter corresponding to each battery is connected to the PCS 400 through a DC link.

The DC-DC converter may be a bidirectional converter, wherein when conversion is performed from the battery to the load direction, the input of the DC-DC converter is connected to a battery (a battery unit, a battery rack or a battery pack) and the output of the DC-DC converter may be connected to a load. As examples of the DC-DC converter, various types of converters such as a full-bridge converter, a half-bridge converter, and a flyback converter may be used.

Meanwhile, communication among the BMS 100 , the BSC 200, the PMS 300, and the PCS 400 may be implemented through a controller area network (CAN) or Ethernet (indicated by a dotted line in FIG. 1).

In such an ESS system as described above, a central controller in the system generally calculates an output value of a battery every moment, and transmits the calculated value as a command to each battery (high level control). However, the high level control is possible only when a system voltage of the energy system is maintained, that is, a low level control needs to be preceded.

Referring to FIG. 1, a DC link, which is a region between the DC/DC converter and the PCS, has a DC voltage, and the voltage of the DC link may be generally referred to as a system voltage. For stability of the energy storage system as a whole, the system voltage needs to be maintained within a constant level.

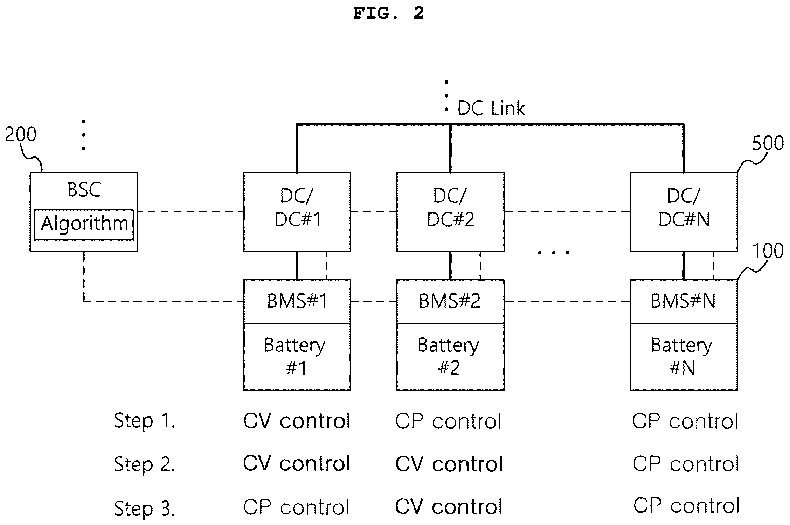

FIG. 2 is a conceptual diagram of a control method of an energy storage system according to embodiments of the present invention.

Various types of control method may be used to maintain the voltage of the DC link (i.e., the system voltage) in a constant state. In otehr words, a DC/DC converter and a PCS are a kind of power conversion devices that may perform Constant Voltage (CV) control, Constant Power (CP) control, Constant Current (CC) control, and droop control. Here, the droop control may refer to a control using a droop curve indicating a relationship between a DC link voltage and an output power of the DC/DC converter.

Typically, a PCS performs constant voltage (CV) control or constant power (CP) control. For example, assuming that a PCS performs CP control, a pwer management system (PMS) calculates an output reference of the PCS (a power value to be output by the PCS) and transmits it to the PCS as a command. In this instance, when the PCS that has received the command performs charging and discharging according to the CP control, the voltage at the DC link can be shaken by the charging and discharging of the PCS. Here, it is necessary to perform CV control in which a power converter maintains the voltage of the DC link at a constant level for stable control of the system.

However, as shown in FIG. 2, when an individual DC/DC converter is disposed and used for each battery pack, a plurality of DC/DC converters interworking with the DC link may exist. When two or more DC/DC converters continuously perform DC link voltage control, for example, a circulating current may be generated due to a voltage sensing error or the like. In other words, since two or more power converters cannot be completely identical in fact, a problem of sensing a same voltage into different values may occur, and thus a circulating current or a divergence of control occurs.

Accordingly, as shown in FIG. 2 according to the embodiments of the present invention, one DC/DC converter performs CV control. In step 1 of FIG. 2, a power converter for performing CV control is DC/DC converter 1 and all other DC/DC converters perform CP control.

Meanwhile, the CV control of the DC/DC converter can be performed without a problem if a SOC of a corresponding battery is in an appropriate boundary. However, when the SOC of the corresponding battery reaches a specific upper limit or a lower limit, the output of the DC/DC converter is also limited by this output limiting characteristic of the battery itself, and accordingly, it may be difficult to perform normal CV control.

Therefore, according to embodiments of the present invention, when the battery of the DC/DC converter performing CV control reaches the upper limit of a SOC region or the lower limit of the SOC region, a DC/DC converter connected to another battery may perform CV control.

Here, when a subject of CV control is changed from DC/DC converter 1 to DC/DC converter 2, in step 2, CV control is temporarily performed by both of the two DC/DC converters, thereby maintaining control of the DC link voltage at all times. In step 3 after step 2, control is completely transferred to DC/DC converter 2, only DC/DC converter 2 performs CV control, and DC/DC converter 1 performs CP mode control.

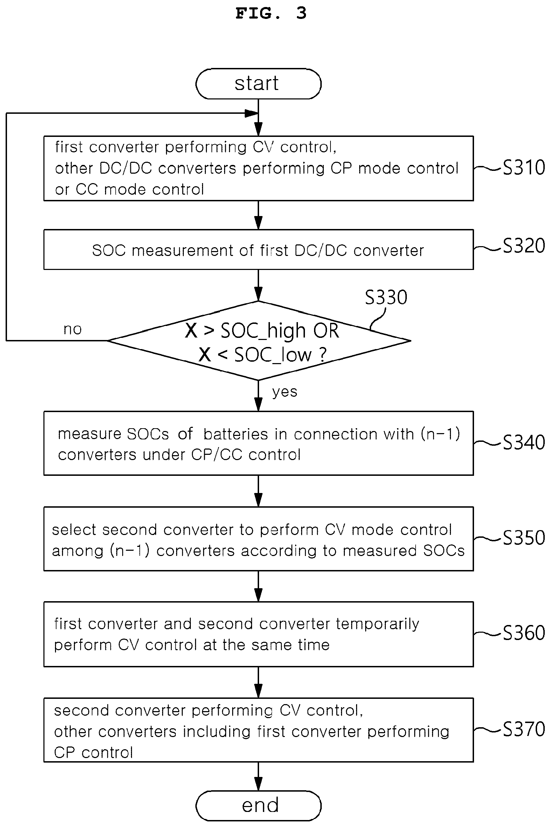

FIG. 3 is an operational flowchart of a method for controlling an energy storage system according to embodiments of the present invention.

The control method shown in FIG. 3 describes how a controlling method of the DC/DC converter is changed from CV control to CP mode or CC mode control, or vice versa. The control method shown in FIG. 3 may be performed by a battery section controller. In other words, a subject of determining a control mode of a DC/DC converter is the battery section controller.

When the DC/DC converter performs CP mode or CC mode control, the BSC calculates an output reference of the DC/DC converter in consideration of a state of charge (SOC) of the battery and transmits it to the DC/DC converter, and the DC/DC converter may decide output value based on the output reference. That is, according to the present invention, active control is possible that determines the output by itself according to a state of the battery.

Referring to FIG. 3, in a power control method according to the present invention, one DC/DC converter among a plurality of DC/DC converters performs CV control on a DC link. Therefore, for example, if n DC/DC converters are disposed in the system and a first converter performs CV control, all of the rest DC/DC converters perform CP mode control or CC mode control (S310).

In this state, a SOC measurement for the first DC/DC converter performing CV mode control may be periodically performed (S320). When the measured SOC of the first DC/DC converter is within an appropriate range (NO in S330), the CV mode control by the first converter is continuously performed.

However, when the SOC of the first DC/DC converter is out of the appropriate range, that is, when the SOC of the first DC/DC converter is greater than an upper limit value (SOC_high) of a preset SOC range or less than a lower limit value (SOC_low) (S330 of Yes), it is necessary to change the subject of CV control. Specifically, the BSC may measure SOCs of batteries in connection with (n-1) converters under CP/CC control except for the first converter performing CV mode control among all n converters (S340). Then, the BSC may select a second converter to perform CV mode control among (n-1) converters according to the measured SOCs (S350).

Here, a procedure for selecting a new converter to perform CV mode control may be performed using Equations 1 and 2 below.

[Equation 1]

$$Diff\_n = \max\{(x - SOC\_low), (SOC\_high - x)\}$$

In equation 1, x is a SOC of a corresponding battery, SOC_high is the upper limit of a preset SOC range, and SOC_low is the lower limit of the preset SOC range. For a battery with a typical SOC, x will be a value greater than or equal to SOC_low and less than or equal to SOC_high (i.e., $0 < SOC\_low < x < SOC\_high < 100$).

[Equation 2]

$$Next\_CV\_converter = a\ DC/DC\ converter\ with\ min\ \{Diff\_1,\ Diff\_2,\ ...,\ Diff\_n\text{-}1\}$$

Through equation 1, a SOC deviation (Diff) of each battery, that is, the larger of the difference between the upper limit value or the lower limit value compared to the current SOC of a corresponding battery, may be calculated. In addition, a new DC/DC converter (Next_CV_converter) to perform CV control may be selected through equation 2. According to equation 2, a converter having an SOC of the minimum deviation, that is, a converter having a value at an intermediate position within a preset SOC range, may be selected as a converter suitable for performing the next CV control. As such, when the converter having the intermediate position value within a preset SOC range performs CV control, CV control can be maintained for the longest, and thus, a frequent control mode switching can be prevented.

The converter selection procedure usinge equations 1 and 2 can be useed not only when changing a subject to perform CV control during system operation, but also when selecting a DC/DC converter to perform initial CV mode control during an initial operation of the system. In other words, equations 1 and 2 may be used even when a first converter is selected in step S310, and in this instance, the SOC measurements may be done for all DC/DC converters in the system.

Meanwhile, when the second converter to perform CV control is selected, the first converter and the second converter temporarily perform CV control at the same time (S360), which is for stably maintaining the voltage of the DC link as mentioned above.

After a certain short period of time has elapsed, only the second converter performs CV control, and all other converters including the first converter perform CP mode or CC mode control (S370).

According to the embodiments of the present invention as described above, it is possible to stably control the DC link voltage in an energy storage system using a plurality of DC/DC converters.

In addition, the DC/DC converters, other than the DC/DC converter that performs CV control, perform CP control or CC control, so that the BSC can actively calculate an output reference of each battery based on a state of each battery.

In another aspect, in general, a power conversion system in an existing energy storage system that does not include a DC/DC converter is generally driven by a CP or CC control method. When a control method according to the embodiments of the present invention is applied to a battery system to which a DC/DC converter is applied, the power conversion system in the ESS may operate in the same manner as the method used in the existing system. In other words, according to the embodiments of the present invention, even if a DC/DC converter is used in the battery system, there is no need to change a software of the power conversion system, and thus the power conversion system can be used as it is previously used.

The embodiments of the present disclosure may be implemented as program instructions executable by a variety of computers and recorded on a computer readable medium. The computer readable medium may include a program instruction, a data file, a data structure, or a combination thereof. The program instructions recorded on the computer readable medium may be designed and configured specifically for the present disclosure or can be publicly known and available to those who are skilled in the field of computer software.

Examples of the computer readable medium may include a hardware device such as ROM, RAM, and flash memory, which are specifically configured to store and execute the program instructions. Examples of the program instructions include machine codes made by, for example, a compiler, as well as high-level language codes executable by a computer, using an interpreter. The above example hardware device can be configured to operate as at least one software module in order to perform the embodiments of the present disclosure, and vice versa.

Some aspects of the present invention have been described above in the context of a device but may be described using a method corresponding thereto. Here, blocks or the device corresponds to operations of the method or characteristics of the operations of the method. Similarly, aspects of the present invention described above in the context of a method may be described using blocks or items corresponding thereto or characteristics of a device corresponding thereto. Some or all of the operations of the method may be performed, for example, by (or using) a hardware device such as a microprocessor, a programmable computer or an electronic circuit. In some embodiments, one or more of most important operations of the method may be performed by such a device.

While the example embodiments of the present invention and their advantages have been described in detail, it should be understood that various changes, substitutions and alterations may be made herein without departing from the scope of the invention.

**EP 4 195 449 B1**

**Claims**

1. An energy storage system comprising:

   a plurality of power converters (500) configured to perform a DC/DC conversion for a plurality of respective battery racks, respectively;
   a power conversion system, PCS, (400) configured to perform power conversion between the power converters (500) and a power grid (600); and
   a battery section controller (200) interworking with the plurality of power converters (500) and the power conversion system (400), wherein the battery section controller (200) is configured:

   to control a first power converter among the plurality of power converters (500) to perform constant voltage (CV) mode control for maintaining a voltage of a DC link at a constant level, and
   to check a state of a first battery rack to which the first power converter is connected among the plurality of battery racks,
   **characterized in that** the battery section controller (200) is also configured to select a second power converter among the plurality of power converters (500) to perform the CV mode control for the DC link according to the state of the first battery rack,
   control the first power converter and the second power converter to simultaneously perform the CV mode control for the DC link temporarily;
   then stop the first power converter from performing the CV mode control for the DC link; and
   control the second power converter among the plurality of power converters (500) to continue performing the CV mode control for the DC link.

2. The energy storage system of claim 1, wherein the battery section controller is further configured to control the power converters other than the first power converter among the plurality of power converters to perform a constant power (CP) mode control or a constant current (CC) mode control.

3. The energy storage system of claim 1, wherein the battery section controller (200) is further configured to select a power converter among the plurality of power converters (500) except for the first power converter as the second power converter to perform the CV mode control for the DC link instead of the first power converter, and
   wherein the second power converter is connected to a battery rack with an intermediate SOC value among the SOC values of the battery racks connected to the power converters (500) other than the first power converter.

4. The energy storage system of claim 1, wherein the battery section controller (200) is further configured to determine whether a state of charge (SOC) of the first battery rack has reached an upper limit or a lower limit of a preset range of SOC and to decide whether to select the second power converter to perform the CV mode control for the DC link.

5. The energy storage system of claim 1, wherein the DC link is a link between the plurality of power converters (500) and the power conversion system, PCS, (400).

6. A control method of an energy storage system including a plurality of battery racks and a plurality of power converters (500) respectively connected to the plurality of battery racks, the method comprising:

   controlling (S310) a first power converter among the plurality of power converters (500) to perform constant voltage (CV) mode control for maintaining a voltage of a DC link at a constant level; and
   checking (S320) a state of a first battery rack to which the first power converter is connected among the plurality of battery racks;
   **characterized by** selecting (S350) a second power converter among the plurality of power converters (500) to perform the CV mode control for the DC link according to the state of the first battery rack;
   controlling (S360) the first power converter and the second power converter to simultaneously perform the CV mode control for the DC link temporarily;
   then stopping the first power converter from performing the CV mode control for the DC link; and
   controlling the second power converter among the plurality of power converters (500) to continue performing the CV mode control for the DC link.

7. The control method of claim 6, further comprising: controlling the power converters (500) other than the first power converter among the plurality of power converters to perform a constant power (CP) mode control or a constant current (CC) mode control.

8. The control method of claim 6, wherein the selecting (S350) of the second power converter further includes:

selecting a power converter among the plurality of power converters (500) except for the first power converter as the second power converter to perform the CV control for the DC link instead of the first power converter, wherein the second power converter is connected to a battery rack with an intermediate SOC value of the battery racks connected to the power converters (500) other than the first power converter.

9. The control method of claim 6, wherein the checking (S320) of the state of the first battery rack includes determining (S330) whether a state of charge of the first battery rack has reached an upper limit or a lower limit of a preset range of state of charge.

10. A battery section controller (200) for use in an energy storage system including a plurality of battery racks and a plurality of power converters (500) respectively connected to the plurality of battery racks, the battery section controller (200) being in connection with the plurality of power converters (500), the battery section controller (200) comprising:

at least one processor; and
a memory configured to store at least one instruction executed by the at least one processor,
wherein the at least one instruction includes:

an instruction to control a first power converter among the plurality of power converters (500) to perform a constant voltage (CV) mode control for maintaining a voltage of a DC link at a constant level; and
an instruction to check a state of a first battery rack to which the first power converter is connected among the plurality of battery racks;
**characterized in that** the at least one instruction also includes an instruction to select a second power converter among the plurality of power converters (500) to perform the CV mode control for the DC link according to the state of the first battery rack;
an instruction to control the first power converter and the second power converter to simultaneously perform the CV mode control for the DC link temporarily;
an instruction to then stop the first power converter from performing the CV mode control for the DC link; and
an instruction to control the second power converter among the plurality of power converters (500) to continue performing the CV mode control for the DC link.

11. The battery section controller of claim 10, wherein the at least one instruction further includes:
an instruction to control the power converters (500) other than the first power converter among the plurality of power converters to perform constant power (CP) mode control or constant current (CC) mode control.

**Patentansprüche**

1. Energiespeichersystem, umfassend:

eine Mehrzahl von Leistungswandlern (500), welche dazu eingerichtet sind, jeweils eine DC/DC-Wandlung für eine Mehrzahl von jeweiligen Batteriegestellen durchzuführen;
ein Leistungswandlungssystem, PCS, (400), welches dazu eingerichtet ist, eine Leistungswandlung zwischen den Leistungswandlern (500) und einem Stromnetz (600) durchzuführen; und
eine Batterieabschnitt-Steuereinrichtung (200), welche mit der Mehrzahl von Leistungswandlern (500) und dem Leistungswandlungssystem (400) zusammenwirkt, wobei die Batterieabschnitt-Steuereinrichtung (200) dazu eingerichtet ist:

einen ersten Leistungswandler unter der Mehrzahl von Leistungswandlern (500) derart zu steuern, dass er eine Konstantspannungs- (CV) Modus-Steuerung zum Halten einer Spannung eines DC-Zwischenkreises auf einem konstanten Niveau durchführt, und
einen Zustand eines ersten Batteriegestells, mit welchem der erste Leistungswandler verbunden ist, unter der Mehrzahl von Batteriegestellen zu überprüfen,
**dadurch gekennzeichnet, dass** die Batterieabschnitt-Steuereinrichtung (200) ferner dazu eingerichtet ist, einen zweiten Leistungswandler unter der Mehrzahl von Leistungswandlern (500) auszuwählen, um die CV-Modus-Steuerung für den DC-Zwischenkreis gemäß dem Zustand des ersten Batteriegestells durchzuführen,

den ersten Leistungswandler und den zweiten Leistungswandler derart zu steuern, dass sie vorübergehend gleichzeitig die CV-Modus-Steuerung für den DC-Zwischenkreis durchführen;

dann den ersten Leistungswandler zu stoppen, die CV-Modus-Steuerung für den DC-Zwischenkreis durchzuführen; und

den zweiten Leistungswandler unter der Mehrzahl von Leistungswandlern (500) derart zu steuern, dass er damit fortfährt, die CV-Modus-Steuerung für den DC-Zwischenkreis durchzuführen.

2. Energiespeichersystem nach Anspruch 1, wobei die Batterieabschnitt-Steuereinrichtung ferner dazu eingerichtet ist, die Leistungswandler, welche von dem ersten Leistungswandler unter der Mehrzahl von Leistungswandlern verschieden sind, derart zu steuern, dass sie eine Konstantleistungs- (CP) Modus-Steuerung oder eine Konstantstrom-(CC) Modus-Steuerung durchführen.

3. Energiespeichersystem nach Anspruch 1, wobei die Batterieabschnitt-Steuereinrichtung (200) ferner dazu eingerichtet ist, einen Leistungswandler unter der Mehrzahl von Leistungswandlern (500) mit Ausnahme des ersten Leistungswandlers als den zweiten Leistungswandler auszuwählen, um die CV-Modus-Steuerung für den DC-Zwischenkreis anstelle des ersten Leistungswandlers durchzuführen, und

wobei der zweite Leistungswandler mit einem Batteriegestell mit einem mittleren SOC-Wert unter den SOC-Werten der Batteriegestelle verbunden ist, welche mit den Leistungswandlern (500) verbunden sind, die von dem ersten Leistungswandler verschieden sind.

4. Energiespeichersystem nach Anspruch 1, wobei die Batterieabschnitt-Steuereinrichtung (200) ferner dazu eingerichtet ist, zu bestimmen, ob ein Ladezustand (SOC) des ersten Batteriegestells eine obere Grenze oder eine untere Grenze eines voreingestellten SOC-Bereichs erreicht hat, und zu entscheiden, ob der zweite Leistungswandler zum Durchführen der CV-Modus-Steuerung für den DC-Zwischenkreis ausgewählt werden soll.

5. Energiespeichersystem nach Anspruch 1, wobei der DC-Zwischenkreis eine Verbindung zwischen der Mehrzahl von Leistungswandlern (500) und dem Leistungswandlungssystem, PCS, (400) ist.

6. Steuerungsverfahren für ein Energiespeichersystem, welches eine Mehrzahl von Batteriegestellen und eine Mehrzahl von Leistungswandlern (500) umfasst, welche jeweils mit der Mehrzahl von Batteriegestellen verbunden sind, wobei das Verfahren umfasst:

Steuern (S310) eines ersten Leistungswandlers unter der Mehrzahl von Leistungswandlern (500), um eine Konstantspannungs- (CV) Modus-Steuerung zum Halten einer Spannung eines DC-Zwischenkreises auf einem konstanten Niveau durchzuführen; und

Überprüfen (S320) eines Zustands eines ersten Batteriegestells, mit welchem der erste Leistungswandler verbunden ist, unter der Mehrzahl von Batteriegestellen;

**gekennzeichnet durch** ein Auswählen (S350) eines zweiten Leistungswandlers unter der Mehrzahl von Leistungswandlern (500), um die CV-Modus-Steuerung für den DC-Zwischenkreis gemäß dem Zustand des ersten Batteriegestells durchzuführen;

Steuern (S360) des ersten Leistungswandlers und des zweiten Leistungswandlers, um vorübergehend gleichzeitig die CV-Modus-Steuerung für den DC-Zwischenkreis durchzuführen;

anschließend Stoppen des ersten Leistungswandlers, die CV-Modus-Steuerung für den DC-Zwischenkreis durchzuführen; und

Steuern des zweiten Leistungswandlers unter der Mehrzahl von Leistungswandlern (500), um damit fortzufahren, die CV-Modus-Steuerung für den DC-Zwischenkreis durchzuführen.

7. Steuerungsverfahren nach Anspruch 6, ferner umfassend:
Steuern der Leistungswandler (500), welche von dem ersten Leistungswandler unter der Mehrzahl von Leistungswandlern verschieden sind, um eine Konstantleistungs- (CP) Modus-Steuerung oder eine Konstantstrom-(CC) Modus-Steuerung durchzuführen.

8. Steuerungsverfahren nach Anspruch 6, wobei das Auswählen (S350) des zweiten Leistungswandlers ferner umfasst:

Auswählen eines Leistungswandlers unter der Mehrzahl von Leistungswandlern (500) mit Ausnahme des ersten Leistungswandlers als den zweiten Leistungswandler, um die CV-Steuerung für den DC-Zwischenkreis anstelle des ersten Leistungswandlers durchzuführen,
wobei der zweite Leistungswandler mit einem Batteriegestell mit einem mittleren SOC-Wert der Batteriegestelle verbunden ist, welche mit den Leistungswandlern (500) verbunden sind, die von dem ersten Leistungswandler verschieden sind.

9. Steuerungsverfahren nach Anspruch 6, wobei das Überprüfen (S320) des Zustands des ersten Batteriegestells ein Bestimmen (S330) umfasst, ob ein Ladezustand des ersten Batteriegestells eine obere Grenze oder eine untere Grenze eines voreingestellten Ladezustandsbereichs erreicht hat.

10. Batterieabschnitt-Steuereinrichtung (200) zur Verwendung in einem Energiespeichersystem, welches eine Mehrzahl von Batteriegestellen und eine Mehrzahl von Leistungswandlern (500) umfasst, welche jeweils mit der Mehrzahl von Batteriegestellen verbunden sind, wobei die Batterieabschnitt-Steuereinrichtung (200) mit der Mehrzahl von Leistungswandlern (500) in Verbindung steht, wobei die Batterieabschnitt-Steuereinrichtung (200) umfasst:

wenigstens einen Prozessor; und
einen Speicher, welcher dazu eingerichtet ist, wenigstens eine durch den wenigstens einen Prozessor ausgeführte Anweisung zu speichern,
wobei die wenigstens eine Anweisung umfasst:

eine Anweisung zum Steuern eines ersten Leistungswandlers unter der Mehrzahl von Leistungswandlern (500), um eine Konstantspannungs- (CV) Modus-Steuerung zum Halten einer Spannung eines DC-Zwischenkreises auf einem konstanten Niveau durchzuführen; und
eine Anweisung zum Überprüfen eines Zustands eines ersten Batteriegestells, mit welchem der erste Leistungswandler verbunden ist, unter der Mehrzahl von Batteriegestellen;
**dadurch gekennzeichnet, dass** die wenigstens eine Anweisung auch eine Anweisung zum Auswählen eines zweiten Leistungswandlers unter der Mehrzahl von Leistungswandlern (500) umfasst, um die CV-Modus-Steuerung für den DC-Zwischenkreis gemäß dem Zustand des ersten Batteriegestells durchzuführen;
eine Anweisung zum Steuern des ersten Leistungswandlers und des zweiten Leistungswandlers, um vorübergehend gleichzeitig die CV-Modus-Steuerung für den DC-Zwischenkreis durchzuführen;
eine Anweisung zum anschließenden Stoppen des ersten Leistungswandlers, die CV-Modus-Steuerung für den DC-Zwischenkreis durchzuführen; und
eine Anweisung zum Steuern des zweiten Leistungswandlers unter der Mehrzahl von Leistungswandlern (500), um damit fortzufahren, die CV-Modus-Steuerung für den DC-Zwischenkreis durchzuführen.

11. Batterieabschnitt-Steuereinrichtung nach Anspruch 10, wobei die wenigstens eine Anweisung ferner umfasst:
eine Anweisung zum Steuern der Leistungswandler (500), welche von dem ersten Leistungswandler unter der Mehrzahl von Leistungswandlern verschieden sind, um eine Konstantleistungs- (CP) Modus-Steuerung oder eine Konstantstrom- (CC) Modus-Steuerung durchzuführen.


**Revendications**

1. Système de stockage d'énergie comprenant :

une pluralité de convertisseurs de puissance (500) configurés pour effectuer une conversion CC/CC pour une pluralité de bâtis de batterie respectifs, respectivement ;
un système de conversion de puissance, PCS, (400) configuré pour effectuer une conversion de puissance entre les convertisseurs de puissance (500) et un réseau électrique (600) ; et
un contrôleur de section de batterie (200) interagissant avec la pluralité de convertisseurs de puissance (500) et le système de conversion de puissance (400), dans lequel le contrôleur de section de batterie (200) est configuré pour :

commander un premier convertisseur de puissance parmi la pluralité de convertisseurs de puissance (500) pour effectuer une commande en mode tension constante (CV) afin de maintenir une tension d'une liaison CC à un niveau constant, et
vérifier un état d'un premier bâti de batterie auquel le premier convertisseur de puissance est connecté parmi la pluralité de bâtis de batterie,

**caractérisé en ce que** le contrôleur de section de batterie (200) est également configuré pour sélectionner un second convertisseur de puissance parmi la pluralité de convertisseurs de puissance (500) pour effectuer la commande en mode CV pour la liaison CC en fonction de l'état du premier bâti de batterie, commander le premier convertisseur de puissance et le second convertisseur de puissance pour effectuer simultanément la commande en mode CV pour la liaison CC temporairement ; puis arrêter l'exécution par le premier convertisseur de puissance de la commande en mode CV pour la liaison CC ; et commander le second convertisseur de puissance parmi la pluralité de convertisseurs de puissance (500) pour continuer à effectuer la commande en mode CV pour la liaison CC.

2. Le système de stockage d'énergie selon la revendication 1, dans lequel le contrôleur de section de batterie est en outre configuré pour commander les convertisseurs de puissance autres que le premier convertisseur de puissance parmi la pluralité de convertisseurs de puissance pour effectuer une commande en mode puissance constante (CP) ou une commande en mode courant constant (CC).

3. Le système de stockage d'énergie selon la revendication 1, dans lequel le contrôleur de section de batterie (200) est en outre configuré pour sélectionner un convertisseur de puissance parmi la pluralité de convertisseurs de puissance (500), à l'exception du premier convertisseur de puissance, en tant que second convertisseur de puissance pour effectuer la commande en mode CV pour la liaison CC à la place du premier convertisseur de puissance, et dans lequel le second convertisseur de puissance est connecté à un bâti de batterie ayant une valeur de SOC intermédiaire parmi les valeurs de SOC des bâtis de batterie connectés aux convertisseurs de puissance (500) autres que le premier convertisseur de puissance.

4. Le système de stockage d'énergie selon la revendication 1, dans lequel le contrôleur de section de batterie (200) est en outre configuré pour déterminer si un état de charge (SOC) du premier bâti de batterie a atteint une limite supérieure ou une limite inférieure d'une plage prédéfinie de SOC et pour décider s'il convient de sélectionner le second convertisseur de puissance pour effectuer la commande en mode CV pour la liaison CC.

5. Le système de stockage d'énergie selon la revendication 1, dans lequel la liaison CC est une liaison entre la pluralité de convertisseurs de puissance (500) et le système de conversion de puissance, PCS, (400).

6. Procédé de commande d'un système de stockage d'énergie incluant une pluralité de bâtis de batterie et une pluralité de convertisseurs de puissance (500) respectivement connectés à la pluralité de bâtis de batterie, le procédé comprenant :

la commande (S310) d'un premier convertisseur de puissance parmi la pluralité de convertisseurs de puissance (500) pour effectuer une commande en mode tension constante (CV) afin de maintenir une tension d'une liaison CC à un niveau constant ; et
la vérification (S320) d'un état d'un premier bâti de batterie auquel le premier convertisseur de puissance est connecté parmi la pluralité de bâtis de batterie ;
**caractérisé par** la sélection (S350) d'un second convertisseur de puissance parmi la pluralité de convertisseurs de puissance (500) pour effectuer la commande en mode CV pour la liaison CC en fonction de l'état du premier bâti de batterie ;
la commande (S360) du premier convertisseur de puissance et du second convertisseur de puissance pour effectuer simultanément la commande en mode CV pour la liaison CC temporairement ;
puis l'arrêt de l'exécution par le premier convertisseur de puissance de la commande en mode CV pour la liaison CC ; et
la commande du second convertisseur de puissance parmi la pluralité de convertisseurs de puissance (500) pour continuer à effectuer la commande en mode CV pour la liaison CC.

7. Le procédé de commande selon la revendication 6, comprenant en outre :
la commande des convertisseurs de puissance (500) autres que le premier convertisseur de puissance parmi la pluralité de convertisseurs de puissance pour effectuer une commande en mode puissance constante (CP) ou une commande en mode courant constant (CC).

8. Le procédé de commande selon la revendication 6, dans lequel la sélection (S350) du second convertisseur de puissance inclut en outre :

la sélection d'un convertisseur de puissance parmi la pluralité de convertisseurs de puissance (500), à l'exception du premier convertisseur de puissance, en tant que second convertisseur de puissance pour effectuer la commande CV pour la liaison CC à la place du premier convertisseur de puissance,

dans lequel le second convertisseur de puissance est connecté à un bâti de batterie ayant une valeur de SOC intermédiaire des bâtis de batterie connectés aux convertisseurs de puissance (500) autres que le premier convertisseur de puissance.

9. Le procédé de commande selon la revendication 6, dans lequel la vérification (S320) de l'état du premier bâti de batterie inclut la détermination (S330) consistant à savoir si un état de charge du premier bâti de batterie a atteint une limite supérieure ou une limite inférieure d'une plage prédéfinie d'état de charge.

10. Contrôleur de section de batterie (200) destiné à être utilisé dans un système de stockage d'énergie incluant une pluralité de bâtis de batterie et une pluralité de convertisseurs de puissance (500) respectivement connectés à la pluralité de bâtis de batterie, le contrôleur de section de batterie (200) étant en liaison avec la pluralité de convertisseurs de puissance (500), le contrôleur de section de batterie (200) comprenant :

au moins un processeur ; et
une mémoire configurée pour stocker au moins une instruction exécutée par l'au moins un processeur,
dans lequel l'au moins une instruction inclut :

une instruction pour commander un premier convertisseur de puissance parmi la pluralité de convertisseurs de puissance (500) pour effectuer une commande en mode tension constante (CV) afin de maintenir une tension d'une liaison CC à un niveau constant ; et
une instruction pour vérifier un état d'un premier bâti de batterie auquel le premier convertisseur de puissance est connecté parmi la pluralité de bâtis de batterie ;
**caractérisé en ce que** l'au moins une instruction inclut également une instruction pour sélectionner un second convertisseur de puissance parmi la pluralité de convertisseurs de puissance (500) pour effectuer la commande en mode CV pour la liaison CC en fonction de l'état du premier bâti de batterie ;
une instruction pour commander le premier convertisseur de puissance et le second convertisseur de puissance pour effectuer simultanément la commande en mode CV pour la liaison CC temporairement;
une instruction pour arrêter ensuite l'exécution par le premier convertisseur de puissance de la commande en mode CV pour la liaison CC ; et
une instruction pour commander le second convertisseur de puissance parmi la pluralité de convertisseurs de puissance (500) pour continuer à effectuer la commande en mode CV pour la liaison CC.

11. Le contrôleur de section de batterie selon la revendication 10, dans lequel l'au moins une instruction inclut en outre :
une instruction pour commander les convertisseurs de puissance (500) autres que le premier convertisseur de puissance parmi la pluralité de convertisseurs de puissance pour effectuer une commande en mode puissance constante (CP) ou une commande en mode courant constant (CC).

**FIG. 1**

———— : power line
------ : communication line

FIG. 2

| | | DC Link |
|---|---|---|
| 200 | | 500 |

| BSC | DC/DC#1 | DC/DC#2 | DC/DC#N |
|---|---|---|---|
| Algorithm | | | |

| BMS#1 | BMS#2 | BMS#N |
|---|---|---|
| Battery #1 | Battery #2 | Battery #N |

100

| | | | |
|---|---|---|---|
| Step 1. | CV control | CP control | CP control |
| Step 2. | CV control | CV control | CP control |
| Step 3. | CP control | CV control | CP control |

EP 4 195 449 B1

FIG. 3

```
                          ( start )
                              │
    ┌─────────────────────────┤
    │          ┌──────────────▼──────────────────────────┐
    │          │ first converter performing CV control,   │
    │          │ other DC/DC converters performing CP mode│──S310
    │          │ control or CC mode control               │
    │          └──────────────┬──────────────────────────┘
    │                         │
    │          ┌──────────────▼──────────────────────────┐
    │          │ SOC measurement of first DC/DC converter │──S320
    │          └──────────────┬──────────────────────────┘
    │                         │               S330
    │         no       ◇──────▼──────◇
    └─────────────────◇ X > SOC_high OR ◇
                       ◇ X < SOC_low ?   ◇
                        ◇──────┬──────◇
                               │ yes
               ┌───────────────▼──────────────────────────┐
               │ measure SOCs of batteries in connection   │
               │ with (n−1) converters under CP/CC control │──S340
               └───────────────┬──────────────────────────┘
               ┌───────────────▼──────────────────────────┐
               │ select second converter to perform CV mode│
               │ control among (n−1) converters according  │──S350
               │ to measured SOCs                          │
               └───────────────┬──────────────────────────┘
               ┌───────────────▼──────────────────────────┐
               │ first converter and second converter      │
               │ temporarily perform CV control at the     │──S360
               │ same time                                 │
               └───────────────┬──────────────────────────┘
               ┌───────────────▼──────────────────────────┐
               │ second converter performing CV control,   │
               │ other converters including first converter│──S370
               │ performing CP control                     │
               └───────────────┬──────────────────────────┘
                               │
                          (  end  )
```

**EP 4 195 449 B1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 20180090673 A